(19) Europäisches Patentamt / European Patent Office / Office européen des brevets

(11) **EP 2 933 695 B1**

(12) **EUROPÄISCHE PATENTSCHRIFT**

(45) Veröffentlichungstag und Bekanntmachung des Hinweises auf die Patenterteilung:
**01.03.2017 Patentblatt 2017/09**

(51) Int Cl.:
**G05B 17/02** *(2006.01)*        **G01R 31/317** *(2006.01)*
**G05B 23/02** *(2006.01)*

(21) Anmeldenummer: **14165123.2**

(22) Anmeldetag: **17.04.2014**

(54) **Computerimplementiertes Verfahren zum Echtzeittest eines Steuergeräts**

Computer implemented method for real time testing of a controller

Procédé implémenté par ordinateur pour un test en temps réel d'un appareil de commande

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**21.10.2015 Patentblatt 2015/43**

(73) Patentinhaber: **dSPACE digital signal processing and control engineering GmbH 33102 Paderborn (DE)**

(72) Erfinder:
• **Ha, Quang**
  **33102 Paderborn (DE)**
• **Puschmann, Frank**
  **33014 Bad Driburg (DE)**
• **Aust, Martin**
  **33142 Büren (DE)**

(56) Entgegenhaltungen:
• **AXEL KIFFE ET AL: "Real-time simulation of power electronic circuits based on discrete averaging method", IECON 2011 - 37TH ANNUAL CONFERENCE ON IEEE INDUSTRIAL ELECTRONICS SOCIETY, IEEE, 7. November 2011 (2011-11-07), Seiten 1542-1547, XP032104710, DOI: 10.1109/IECON.2011.6119536 ISBN: 978-1-61284-969-0**

**Beschreibung**

Die Erfindung betrifft ein computerimplementiertes Verfahren zum Echtzeittest eines Steuergeräts mit einem Simulator, wobei der Simulator eine Simulator-I/O-Schnittstelle umfasst, wobei das Steuergerät eine Steuergerät-I/O-Schnittstelle umfasst und wobei das Steuergerät und der Simulator über ihre I/O-Schnittstellen mittels wenigstens eines Datenkanals miteinander verbunden sind und das Steuergerät dem Simulator über den Datenkanal Stromrichtersteuerdaten übermittelt, der Simulator mittels der Stromrichtersteuerdaten und mittels eines elektrischen Lastmodells ohne Berücksichtigung von durch den Stromrichter verursachten Stromlücken als elektrische Lastzustandsgrößen einen Laststrom und eine Lastspannung berechnet und zumindest einen Teil der Lastzustandsgrößen an das Steuergerät übermittelt.

Verfahren der beschriebenen Art zum Steuergerätetest sind seit längerem bekannt und werden in vielen Bereichen der Steuergeräteentwicklung dann verwendet, wenn das Steuergerät bzw. die auf dem Steuergerät implementierte Algorithmik auf eine richtige Funktionalität hin überprüft werden soll, ohne dass das Steuergerät in seine "echte" Arbeitsumgebung gebracht werden muss. Im vorliegenden Fall erzeugt das Steuergerät Stromrichtersteuerdaten, die zur geeigneten Ansteuerung von Leistungsschaltern eines Stromrichters dienen, die üblicherweise mittels Halbleiterschaltelementen (IGBT, IGCT usw.) realisiert sind. Stromrichter dienen der Energieumformung zwischen einer Energiequelle und einer elektrischen Last. Durch Ansteuern der Leistungsschalter des Stromrichters kann der Stromrichter zwischen Gleich- und Wechselspannung bzw. zwischen Gleich- und Wechselstrom vermitteln. Stellt die Energiequelle eine Gleichspannung zur Verfügung und treibt über den Stromrichter eine Last mit Wechselspannung, dann arbeitet der Stromrichter als Wechselrichter, im umgekehrten Fall - die Energiequelle stellt eine Wechselspannung zur Verfügung und treibt damit über den Stromrichter eine Last mit Gleichspannung - arbeitet der Stromrichter als Gleichrichter.

Unabhängig von der Arbeitsweise des Stromrichters dient der Simulator in dem hier betrachteten Anwendungsfall dazu, sowohl den Stromrichter mit seinen Leistungsschaltern wie auch die durch den Stromrichter gespeiste elektrische Last nachzubilden. Das real vorhandene Steuergerät wird demnach als "Hardware-in-the-Loop" mit dem Simulator zusammen betrieben, wobei der Simulator mit Hilfe eines elektrischen Lastmodells, das die elektrische Last mathematisch nachbildet, und unter Verwendung der von dem Steuergerät stammenden Stromrichtersteuerdaten die elektrischen Lastzustandsgrößen berechnet und gegebenenfalls an das Steuergerät zurückübermittelt. Der so realisierte Hardware-in-the-Loop-Test des Steuergeräts ermöglicht reproduzierbare, sichere, automatisierte und damit letztendlich kostengünstige Testabläufe unter Laborbedingungen.

AXEL KIFFE ET AL: "Real-time simulation of power electronic circuits based on discrete averaging method", IECON 2011 - 37TH ANNUAL CONFERENCE ON IEEE INDUSTRIAL ELECTRONICS SOCIETY, IEEE, 7. November 2011 (2011-11-07), Seiten 1542-1547, offenbart eine Echtzeit-Simulation zur Prüfung von elektronischen Steuergeräten für Leistungselektronik.

In den meisten in der Praxis vorkommenden Anwendungsfällen weist die elektrische Last einen induktiven Anteil auf, der eine unstetige Änderung des Laststroms verhindert. Damit nach Betätigung der Leistungsschalter des Stromrichters und der damit ggf. verbundenen Spannungsumkehr an der elektrischen Last der Laststrom gleichwohl in die vor dem Umschaltzeitpunkt fließende Richtung auch weiterfließen kann, sind den Leistungsschaltern der Stromrichter üblicherweise Dioden anti-parallel geschaltet, die den Strom noch so lange führen können, bis der Strom zu Null wird; dann sperren die Dioden.

Für den Fall, dass der Laststrom zu Null wird, wenn alle die Last speisenden Leistungsschalter des Stromrichters sperren, bleibt der Strom so lange auf Null, bis einer der speisenden Leistungsschalter wieder auf leitend geschaltet wird, also eine Verbindung zur speisenden negativen oder positiven Versorgungsspannung geschaltet wird. Das Verharren des Laststromes auf Null wird üblicherweise als Stromlücke bezeichnet, der Betriebszustand wird Lückbetrieb genannt. Stromlücken treten beispielsweise auf bei bürstenlosen Gleichstrommotoren und solchen Betriebsarten von Wechselrichtern, bei denen von der komplementären Ansteuerung der Leistungsschalter abgewichen wird. Ferner tritt das Stromlücken bei Sonderfällen auf, wie zum Beispiel dem Kurzschlussbremsen von permanent erregten Synchronmaschinen, aber auch bei elektrischen Fehlern.

Auch wenn die Ursachen für das Stromlücken elektrotechnisch ohne weiteres nachvollziehbar und die resultierenden Stromverläufe auch unter Berücksichtigung des Stromlückens dem Grunde nach vergleichsweise einfach berechenbar sind, stellt die Berechnung von Zustandsgrößen in stromrichtergespeisten elektrischen Lasten unter Echtzeitbedingungen durchaus ein erhebliches Problem dar. Die Schwierigkeit bei der Berechnung von Lastzustandsgrößen im Lückbetrieb besteht darin, dass das Lastmodell bei einsetzendem Stromlücken eine strukturelle Umschaltung erfährt, der Laststrom kann dann nicht mehr unter Verwendung der gleichungsmäßigen Lastbeschreibung berechnet werden, die bei freien Strompfaden zum Einsatz kommen. Die numerische Behandlung derartiger Strukturumschaltungen ist kein Problem grundsätzlicher Natur, ist aber häufig unter Echtzeitanforderungen nicht zu leisten.

Wenn das Lastmodell nicht in Echtzeit - eine Sekunde Simulationszeit entspricht einer Sekunde Echtzeit - berechnet werden muss, also praktisch beliebig viel Zeit zur Verfügung steht, dann können z. B. Berechnungsverfahren mit variabler Schrittweite und Nulldurchgangserkennung eingesetzt werden, um die internen Schaltzeitpunkte des Stromrichters, also beispielsweise das Stromlücken aufgrund des eintretenden Sperrens von Dioden, mit hoher Genauigkeit zu erkennen, so dass das Lastmodell auch unter Berücksichtigung des Stromlückens mit hoher Präzision berechnet werden kann. Numerische Verfahren mit variabler Schrittweite und numerische Verfahren zur Nullpunktbestimmung, die ihrerseits oft iterativ arbeiten, ermöglichen zwar die Einhaltung einer vorgegebenen Fehlergrenze, jedoch kann die erforderliche Zeit für einen Berechnungsschritt erheblichen Schwankungen unterliegen, so dass sich Echtzeitbedingungen nicht mit Sicherheit einhalten lassen.

Werden alternativ die für Echtzeitsimulationen bewährten numerischen Verfahren mit konstanter Schrittweite eingesetzt, so muss die Berechnungsschrittweite sehr klein gewählt werden, um Strom-Nulldurchgänge mit nur geringer Verzögerung zu erkennen, so dass durch die verspätete Berücksichtigung interner Schaltereignisse hervorgerufene Ungenauigkeiten möglichst klein bleiben. Das Verhältnis von Schaltperiodendauer des Stromrichters zu der Schrittweite der Echtzeitberechnung sollte im Bereich >100 liegen, da interne Schaltereignisse, die zu einem Stromlücken führen, sonst nur mit einer zeitlichen Auflösung schlechter als 1 % - bezogen auf die Schaltperiodendauer des Umrichters - erfasst werden. Es ist ohne weiteres ersichtlich, dass eine derartige Überabtastung unter Echtzeitbedingungen eine sehr schnelle Berechnung des Lastmodells innerhalb eines Simulationsschritts auf dem Simulator erforderlich macht. Dies ist unter dem Einsatz konventioneller Prozessoren in Simulatoren derzeit allenfalls für sehr niedrige Schaltfrequenzen im Bereich von beispielsweise 1 kHz realisierbar (was bei der vorgeschlagenen einhundertfachen Überabtastung immerhin eine Berechnungsschrittweite von nur 10 μs bedeutete).

Aus den vorgenannten Gründen werden zur Berechnung der Lastzustandsgrößen einer über einen Stromrichter angesteuerten elektrischen Last häufig sogenannte Mittelwertmodelle als Lastmodell verwendet, bei denen bewusst darauf verzichtet wird, interne Schaltvorgänge innerhalb der Schaltperiode des Stromrichters zu berücksichtigen und auflösen zu können und bei denen auch der Verlauf der Lastzustandsgrößen innerhalb einer Schaltperiode des Umrichters nicht von Interesse ist. Bei Mittelwertmodellen wird nicht der Augenblickswert der interessierenden Lastzustandsgröße zum Abtastzeitpunkt berechnet, sondern es wird vielmehr der Mittelwert der Lastzustandsgröße über das vergangene Berechnungsintervall berechnet. Stimmt die Berechnungsperiode des Lastmodells mit der Schaltperiode des Stromrichters überein, stellt das Mittelwertmodell die Mittelwerte der Lastströme und -spannungen über die letzte Schaltperiode dar. Nachteil dieses Verfahrens zur Berechnung von Lastzustandsgrößen mittels eines elektrischen Lastmodells, das von dem Stromrichter verursachte Stromlücken nicht berücksichtigt, ist ein im Fall des Stromlückens unvermeidbarer Berechnungsfehler. Ein solcher Berechnungsfehler kann sich beispielsweise in nicht abklingenden Residuen oder in Dauerschwingungen um den Stromnullpunkt äußern auch wenn der tatsächliche Laststrom eigentlich vollständig zum Erliegen kommen müsste.

Aufgabe der vorliegenden Erfindung ist es, den Echtzeittest eines Steuergeräts mit höherer Präzision durchzuführen zu können, auch wenn zur Simulation der elektrischen Last ein Lastmodell ohne Berücksichtigung von durch den Stromrichter verursachter Stromlücken verwendet wird.

Das erfindungsgemäße Verfahren zum Echtzeittest eines Steuergeräts mit einem Simulator, bei dem die zuvor hergeleitete und aufgezeigte Aufgabe gelöst ist, ist zunächst und im Wesentlichen dadurch gekennzeichnet, dass auf dem Simulator zusätzlich ein regelungstechnischer Beobachter ausgeführt wird und der Beobachter unter Berücksichtigung der Stromrichtersteuerdaten und mit einem Beobachter-Lastmodell wenigstens den Laststrom als Lastzustandsgröße berechnet. Der Beobachter ist so ausgestaltet, dass er aus dem berechneten Laststrom einen Nulldurchgang des Laststroms und eine dadurch verursachte Stromlücke detektiert und bei Detektion einer Stromlücke eine elektrische Kompensationsgröße so berechnet, dass bei zusätzlicher Beaufschlagung der elektrischen Last im Lastmodell mit der Kompensationsgröße die Berechnung des Laststroms mit dem Lastmodell mit reduziertem Fehler bei existierenden Stromlücken erfolgt.

Der auf dem Simulator zusätzlich ausgeführte regelungstechnische Beobachter hat den Vorteil, dass das Lastmodell des Simulators, das ein Stromlücken ja gerade nicht berücksichtigt, nicht angepasst werden muss, gleichwohl aber durch das Beobachter-Lastmodell eine Information über ein vorhandenes Stromlücken gewonnen wird. Der Beobachter kann beispielsweise auf einem weiteren Prozessor des Simulators oder auch nur auf einem anderen Kern des ohnehin zum Einsatz kommenden Prozessors gerechnet werden. Der Beobachter kann beispielsweise auch auf einem FPGA (Field Programmable Gate Array) berechnet werden, was naturgemäß Geschwindigkeitsvorteile mit sich bringt. Wenn genügend Rechenleistung vorhanden ist, kann das Beobachter-Lastmodell selbstverständlich auch auf ein- und demselben Prozessor bzw. auch auf ein- und demselben Kern des Prozessors des Simulators zusammen mit dem Lastmodell berechnet werden.

Durch die Berechnung der elektrischen Kompensationsgröße lässt sich die Berechnung des Lastmodells so beeinflussen, dass es - ohne dass eine Strukturumschaltung in der Berechnung erforderlich wäre - am Ende des Berechnungsintervalls ein solches Ergebnis liefert, als wenn das Stromlücken von vornherein berücksichtigt worden wäre. Das Lastmodell kann - beispielsweise als dynamischen Mittelwertmodell - in seiner Einfachheit belassen werden, die Anpassung an den Lückbetrieb im Sinne einer präziseren Berechnung der Lastzustandsgrößen geschieht durch eine Kompensationsgröße, beispielsweise durch eine Spannung, um die diejenige Spannung erhöht bzw. vermindert wird, mit der die elektrische Last auch im Normalbetrieb rechnerisch beaufschlagt wird.

Gemäß einer bevorzugten Ausgestaltung des Verfahrens ist vorgesehen, dass die Berechnung des Beobachter-Lastmodells in Beobachterzeitintervallen erfolgt, die durch externe Schaltereignisse des Stromrichters synchronisiert sind. Dadurch kann eingerichtet werden, dass in den Beobachterzeitintervallen immer die gleiche Abfolge von Schaltereignissen realisiert ist, was verschiedene Vorteile mit sich bringt. Wenn die Last beispielsweise nur aus einem ohmschen und aus einem induktiven Anteil besteht, dann lassen sich die Lösungsfunktionen für den Laststrom ohne weiteres explizit angeben. In Abhängigkeit von den Stromrichtersteuerdaten liegen an der Last verschiedene Spannungen an, die zu durch Exponentialfunktionen beschreibbaren Stromverläufen führen. Pro Schaltperiode des Stromrichters durchlaufen die Leistungsschalter verschiedene Kombinationen von leitenden und sperrenden Zuständen, der Verlauf des Laststromes lässt sich für jedes Intervall durch einen expliziten mathematischen Ausdruck unmittelbar beschreiben, wodurch auch die Nullpunkt-Detektion des Stroms möglich ist. Auch in dem allgemeineren Fall, dass es sich bei der elektrischen Last um ein RLC-Netzwerk handelt, wird die elektrische Last durch lineare Differentialgleichungen beschrieben, für die geschlossene Funktionen als Lösungsfunktion angebbar sind, die für das Beobachter-Lastmodell verwendet werden können; in diesem Fall müssen numerische Verfahren zur Berechnung des Beobachter-Lastmodells nicht eingesetzt werden.

In einer alternativen Ausgestaltung des Verfahrens ist vorgesehen, dass das Beobachter-Lastmodell ein Mittelwertmodell ist, das also seinerseits zunächst interne Schaltereignisse und damit eine Strukturumschaltung des Modells nicht berücksichtigt. Das Beobachter-Lastmodell kann genau wie das ohnehin vorhandene Lastmodell auch durch den Einsatz numerischer Verfahren berechnet werden, beispielsweise durch das Backward-Euler-Verfahren. Dann ist bevorzugt vorgesehen, dass die Berechnung des Beobachter-Lastmodells durch mit dem Lastmodell berechnete Lastzustandsgrößen getrieben wird. Das bedeutet, dass zu Beginn eines Berechnungsintervalls die Ergebnisse aus dem Lastmodell für die Lastzustandsgrößen verwendet werden und als Ausgangspunkt für die Berechnung des Beobachter-Lastmodells dienen. Dies ist insbesondere dann vorteilhaft, wenn berücksichtigt wird, dass das Lastmodell aufgrund der von dem Beobachter-Modell berechneten Kompensationsgröße mit verbesserter Präzision berechnet werden kann. Aus dem Beobachter-Modell heraus müssen ferner nicht zwingend alle Zustandsgrößen berechnet werden, die mit dem Lastmodell ermittelt werden, denn die Aufgabe des Beobachter-Lastmodells besteht im Wesentlichen in der Berechnung der Kompensationsgröße bzw. der Kompensationsgrößen, nicht aber originär in der Berechnung derjenigen Lastzustandsgrößen, für deren Ermittlung das Lastmodell verwendet wird.

Die eingangs hergeleitete Aufgabe wird ferner mittelbar durch ein Computerprogrammprodukt mit einem Computerprogramm gelöst, das Softwaremittel zur Durchführung des zuvor erläuterten Verfahrens aufweist, wenn das Computerprogramm mit einem Simulator ausgeführt wird.

Im Einzelnen gibt es nun verschiedene Möglichkeiten, das erfindungsgemäße Verfahren zum Echtzeittest eines Steuergeräts mit einem Simulator auszugestalten und weiterzubilden. Dazu wird verwiesen auf die dem Patentanspruch 1 nachgeordneten Patentansprüche und auf die Beschreibung bevorzugter Ausführungsbeispiele in Verbindung mit der Zeichnung. In der Zeichnung zeigen

Fig. 1    schematisch ein Steuergerät und einen Simulator zur computerimplementierten Durchführung eines Echtzeit-Steuergerätetests,

Fig. 2    schematisch als elektrotechnisches Schaltbild einen Stromrichter mit einer elektrischen Last (dreiphasig),

Fig. 3    einen möglichen Verlauf von Stromrichtersteuersignalen zur Ansteuerung von Leistungsschaltern des Stromrichters (einphasig),

Fig. 4    schematisch Stromrichtersteuersignale und sich einstellende Lastströme ohne und mit Stromlücken,

Fig. 5    als Blockschaltbild das erfindungsgemäße Verfahren mit Beobachter zur Identifizierung von Stromlücken und Berechnung von Kompensationsgrößen,

Fig. 6    schematisch die Wirkung einer berechneten Kompensationsspannung und zusätzliche Beaufschlagung der elektrischen Last mit der Kompensationsspannung,

Fig. 7    die approximative Berechnung des Stromnulldurchgangs bei Annahme eines linearen Verlaufs des Laststroms und

Fig. 8    die numerische Berechnung eines Laststroms in einem Strang einer Asynchronmaschine ohne und mit Beobachter-Lastmodell.

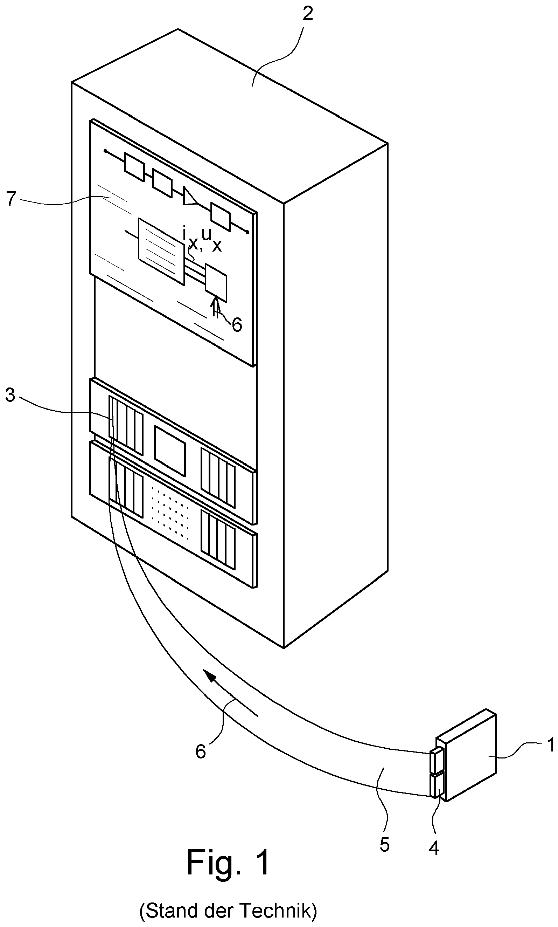

In Fig. 1 ist zunächst eine gerätetechnische Anordnung dargestellt, mit der ein Verfahren zum Echtzeittest eines Steuergeräts 1 mit einem Simulator 2 durchgeführt werden kann. Der Simulator 2 umfasst eine Simulator-I/O-Schnittstelle 3 und das Steuergerät 1 umfasst eine Steuergerät-I/O-Schnittstelle 4. Das Steuergerät 1 und der Simulator 2 sind über ihre I/O-Schnittstellen 3, 4 mittels eines Datenkanals 5 miteinander verbunden. Der Datenkanal 5 kann durch eine einzige serielle Datenleitung realisiert sein, er kann auch über mehrere parallele Datenleitungen realisiert sein, darauf kommt es im vorliegenden Fall nicht an. Von Bedeutung ist, dass das Steuergerät 1 und der Simulator 2 über den Datenkanal 5 Daten austauschen können.

Bei dem Steuergerät 1 handelt es sich um ein zu testendes Steuergerät, auf dem vorliegend ein Algorithmus zur Ansteuerung eines Stromrichters implementiert ist. Das Steuergerät 1 ermittelt infolge seiner Programmierung und gegebenenfalls in Abhängigkeit von externen Daten, die das Steuergerät 1 über seine Steuergerät-I/O-Schnittstelle 4 erhält, Stromrichtersteuerdaten 6 - beispielsweise in Form von pulsweiten-modulierten Signalen (PWM-Signale) - und übermittelt diese an den Simulator 2. Der Simulator 2 enthält weder einen realen Stromrichter, noch eine reale Last, vielmehr werden beide Komponenten in dem Simulator 2 durch ein mathematisches Modell nachgebildet, das hier als elektrisches Lastmodell 7 bezeichnet wird. Der in Fig. 1 dargestellte Aufbau entspricht einem Hardware-in-the-Loop-Test des Steuergeräts 1, die Umgebung des Steuergeräts 1 wird also durch den Simulator 2 und die Berechnungen innerhalb des Simulators 2 nachgebildet.

Bei dem Lastmodell 7 handelt es sich um ein solches Modell, bei dem ein durch einen Stromrichter verursachtes Stromlücken nicht berücksichtigt wird; im dargestellten Fall ist das Lastmodell 7 ein dynamisches Mittelwertmodell einer ohmsch-induktiven Last. Mit dem Lastmodell 7 werden als elektrische Lastzustandsgrößen ein Laststrom $i_x$ und eine Lastspannung $u_x$ berechnet. Zumindest ein Teil der Lastzustandsgrößen wird über den Datenkanal 5 von dem Simulator 2 wieder an das Steuergerät 1 übermittelt, so dass insgesamt eine Regelung implementiert ist.

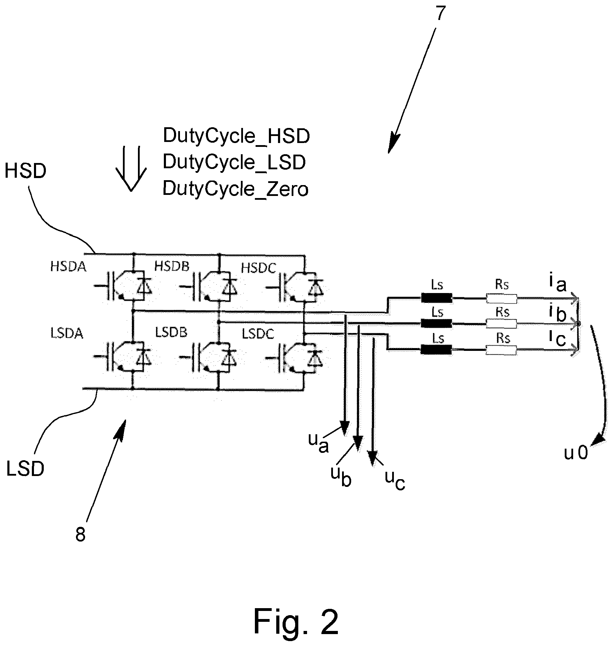

In Fig. 2 sind in Form eines elektrischen Schaltbildes die Komponenten dargestellt, die der Berechnung der elektrischen Lastzustandsgrößen durch den Simulator 2 zugrunde liegen. In diesem Fall ist der Stromrichter 8 dreiphasig aufgebaut und besteht das Lastmodell 7 entsprechend aus drei Strängen (gekennzeichnet durch die Anhänge a, b, c), die jeweils durch ohmsch-induktive Lasten $R_s$, $L_s$ gebildet sind. Es könnte sich bei der Last beispielsweise um eine Asynchronmaschine mit einem zentralen Sternpunkt handeln.

Der Stromrichter 8 besteht je Phase jeweils aus zwei Leistungsschaltern, HSDX, LSDX, über die der jeweilige Laststrang mit der positiven Speisegleichspannung HSD (High Side Drive) und der negativen Speisegleichspannung LSD (Low Side Drive) verbunden werden. Die Leistungsschalter sind hier der Einfachheit halber mit HSDA, LSDA; HSDB, LSDB und HSDC, LSDC bezeichnet. Die Leistungsschalter des Stromrichters 8 werden über Stromrichtersteuerdaten 6 geschaltet, die hier als pulsweitenmodulierte Signale (PWM-Signale) vorliegen. Die PWM-Signale sind in bekannter Weise gekennzeichnet durch ihren Tastgrad, der in Fig. 2 als DutyCycle_HSD, DutyCycle_LSD und DutyCycle_Zero beschrieben ist; diese Daten werden je Phase übermittelt. Die Stromrichtersteuerdaten 6 entscheiden darüber, welche der Leistungsschalter HSDX, LSDX durchgeschaltet sind oder sperren, so dass durch Auswertung der Stromrichtersteuerdaten 6 ersichtlich ist, welche Strangspannungen $u_a$, $u_b$, $u_c$ an den jeweiligen Laststrängen anliegen. Im Fall der in Fig. 2 dargestellten ohmsch-induktiven Lasten besteht das Lastmodell 7 aus linearen Differentialgleichungen für jeden Strang. Bei bekannten speiseseitigen Spannungen $u_x$ können die entsprechenden Lastströme $i_x$ (mit x = a, b, c) berechnet werden.

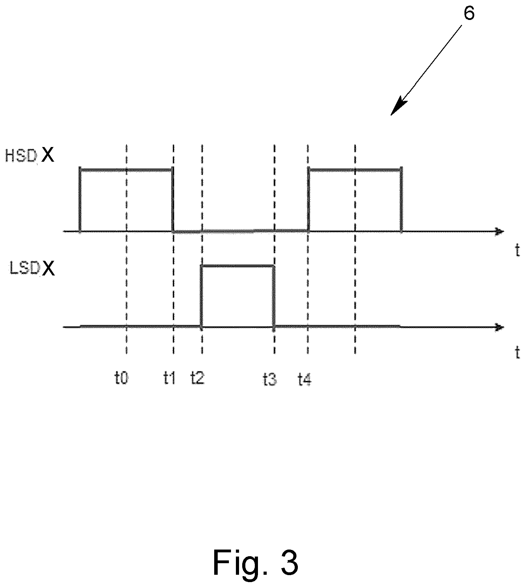

Fig. 3 zeigt für einen Strang exemplarisch mögliche Stromrichtersteuerdaten 6 in Form von PWM-Signalen, die die Leistungsschalter HSDX, LSDX schalten. Aus den in Fig. 3 dargestellten PWM-Signalen als Stromrichtersteuerdaten 6 ergeben sich die folgenden Tastgrade für die positive und negative Speisespannung (HSD, LSD) und für die Zero-Intervalle, in denen keiner der Leistungsschalter durchschaltet:

$$DutyCycle\_HSD = \frac{t_1 - t_0}{T_{PWM}} + \frac{t_5 - t_4}{T_{PWM}}$$

$$DutyCycle\_LSD = \frac{t_3 - t_2}{T_{PWM}}$$

$$DutyCycle\_zero = \frac{t_2 - t_1}{T_{PWM}} + \frac{t_4 - t_3}{T_{PWM}}$$

In den Gleichungen bezeichnet $T_{PWM}$ die Periodendauer des PWM-Signals. Im nichtlückenden Betrieb, wenn also in einem Laststrang entweder wenigstens ein Leistungsschalter HSDX, LSDX durchgeschaltet ist, bzw. wenigstens eine der antiparallel geschalteten Dioden noch leitfähig ist, wird der Laststrom in jedem Strang durch die folgende Differentialgleichung beschrieben (x = a, b, c):

$$L_S \frac{di_x}{dt} = u_x - R_S i_x - u_0$$

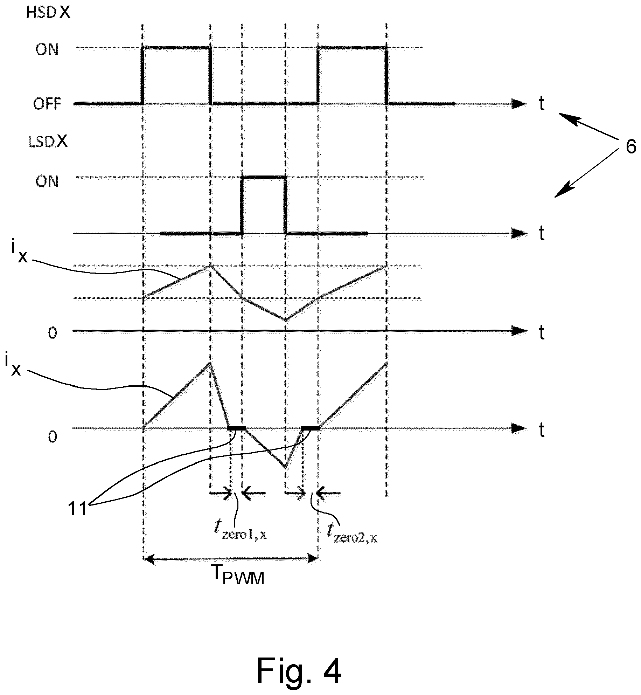

In Fig. 4 sind nochmals in den beiden oberen Teilfiguren für einen Laststrang Stromrichtersteuerdaten 6 in Form von PWM-Signalen dargestellt. Darunter sind mögliche Verläufe von Lastströmen $i_x$ dargestellt. In dem oberen Verlauf des Laststroms $i_x$ bleibt der Strom stets positiv, so dass der Stromfluss auch dann noch gewährleistet ist, wenn beide Leistungsschalter sperren, also sowohl HSDX als auch LSDX sperren (die zugehörigen PWM-Signale sind im Zustand "off"). In dem unteren Verlauf des Laststromes $i_x$ kommt es allerdings zum sogenannten Stromlücken, bei dem der Laststrom $i_x$, der zuvor über die Freilaufdioden geführt worden ist, siehe Fig. 2, zu Null wird. In diesem Fall muss der Laststrom $i_x$ zwingend auf Null bleiben, bis einer der Leistungsschalter HSDX, LSDX wieder durchschaltet. Die Stromlückzeitintervalle sind in Figur 4 mit $t_{zero1}$ und $t_{ze-ro2}$ bezeichnet. Das Auftreten dieses Stromlückens ist insoweit kritisch, als dass mit Lastmodell 7, das den Voraussetzungen entsprechend ein durch den Stromrichter 8 verursachtes Stromlücken nicht berücksichtigt, nur eine fehlerhafte bzw. unpräzise Berechnung der Lastzustandsgrößen und insbesondere des Laststromes $i_x$ ermöglicht.

Die vorgenannte Eigenschaft haben alle Lastmodelle 7, von denen hier ausgegangen wird, gemeinsam. Typische Lastmodelle 7, bei denen der Lückbetrieb von Stromrichtern nicht berücksichtigt wird und praktisch auch nicht berücksichtigbar ist, sind sogenannte Mittelwertmodelle, bei denen der Verlauf der zu berechnenden Zustandsgrößen beispielsweise innerhalb eines PWM-Intervalls nicht interessiert und die mit den Mittelwerten der Lastzustandsgrößen rechnen bzw. diese berechnen.

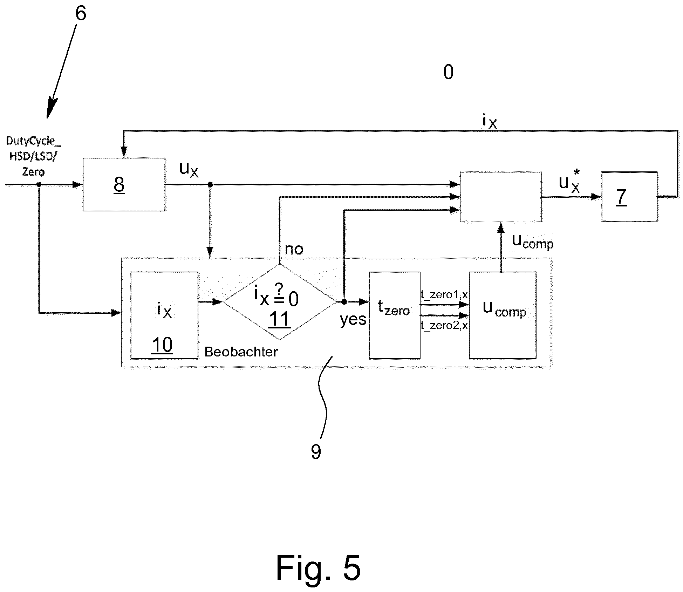

In Fig. 5 ist eine Erweiterung des an sich aus dem Stand der Technik bekannten und zuvor beschriebenen Verfahrens dargestellt, die sich dadurch auszeichnet, dass auf dem Simulator 2 zusätzlich ein regelungstechnischer Beobachter 9 ausgeführt wird, der Beobachter 9 unter Berücksichtigung der Stromrichtersteuerdaten 6 (hier in Form der DutyCycle_HSD/LSD/Zero) und mit einem Beobachter-Lastmodell 10 wenigstens den Laststrom $i_x$ als Lastzustandsgröße berechnet, der Beobachter 9 aus dem berechneten Laststrom $i_x$ einen Nulldurchgang des Laststroms $i_x$ und eine dadurch verursachte Stromlücke 11 detektiert und der Beobachter 9 bei Detektion einer Stromlücke 11 eine elektrische Kompensationsgröße $u_{comp}$ so berechnet, dass bei zusätzlicher Beaufschlagung der elektrischen Last im Lastmodell 7 mit der Kompensationsgröße $u_{comp}$ die Berechnung des Laststroms $i_x$ mit dem Lastmodell 7 mit reduziertem Fehler bei existierenden Stromlücken 11 erfolgt. In dem dargestellten Ausführungsbeispiel geht in die resultierende Spannung $u_x^*$ sowohl die normale Strangspannung $u_x$ ein wie auch die Kompensationsspannung $u_{comp}$.

Die Idee besteht also darin, das Lastmodell 7 in seiner Einfachheit, also ohne Berücksichtigung von durch den Stromrichter 8 verursachtes Stromlücken, zu belassen, aber eine Kompensationsgröße so zu berechnen, dass bei Beaufschlagung der elektrischen Last innerhalb des vorhandenen Lastmodells 7 mit der um die Kompensationsgröße $u_{comp}$ vergrößerten bzw. reduzierten elektrischen Speisegröße das gleiche Ergebnis erzielt wird, wie wenn das Lastmodell 7 ein Stromlücken - beispielsweise durch eine strukturelle Umschaltung der zu berechnenden Gleichungen - berücksichtigte.

Das Prinzip der Kompensation von Fehlern des Lastmodells 7 bei Stromlücken durch Berechnung einer Kompensationsgröße und zusätzliche Beaufschlagung der elektrischen Last im Lastmodell 7 mit der berechneten Kompensationsgröße $u_{comp}$ ist vollkommen unabhängig von der durch das Lastmodell 7 modellierten Last. Typischerweise wird es sich bei der modellierten Last um eine elektrische Maschine, insbesondere um eine Kommutatormaschine, eine Asynchronmaschine oder eine Synchronmaschine handeln, wobei der Strang bzw. die Stränge der Maschinen üblicherweise durch ein RLC-Netzwerk nachgebildet werden, in guter Näherung durch wenigstens ein RL-Netzwerk mathematisch nachgebildet werden.

Bei dem in Fig. 5 dargestellten Ausführungsbeispiel wird die elektrische Last im Beobachter-Lastmodell 10 durch lineare Differentialgleichungen beschrieben, die ein RL-Netzwerk repräsentieren. Das Beobachter-Lastmodell 10 wird durch ein numerisches Verfahren berechnet, hier unter Anwendung des Backward-Euler-Verfahrens. Wie in Fig. 5 zu erkennen ist, wird die Berechnung des Beobachter-Lastmodells 10 durch Lastzustandsgrößen $u_x$ getrieben, die aus dem Lastmodell 7 stammen.

Der Beobachter 9 erkennt durch einen Vorzeichenwechsel des berechneten Laststroms $i_x$ einen Nulldurchgang des Laststroms $i_x$, so dass auf eine dadurch verursachte Stromlücke 11 geschlossen und diese Stromlücke 11 detektiert werden kann. Wenn mit Hilfe des Beobachter-Lastmodells 10 Werte des Laststroms $i_x$ nur jeweils am Ende des der Berechnung zugrundeliegenden Beobachterzeitintervalls berechnet werden, dann erfolgt die Detektion einer Stromlücke 11 durch Auswertung der Werte des Laststroms $i_x$ am Anfang und am Ende des Beobachterzeitintervalls, wobei als zusätzliche Information aus den Stromrichtersteuerdaten 6 erhalten wird, ob der Nulldurchgang des Laststroms $i_x$ in einem Intervall stattgefunden hat, in dem die den Lastpfad speisenden Leistungsschalter gesperrt waren, so dass tatsächlich ein Lückbetrieb vorliegt.

Aus Fig. 5 ergibt sich, dass in dem Fall, in dem kein Stromlücken erkannt wird, das Lastmodell 7 ohne jegliche Anpassung berechnet wird, die zusätzliche Berechnung der Kompensationsgröße $u_{comp}$ unterbleibt dann. Das Lastmodell 7 wird dann mit der Spannung $u_x$ beaufschlagt, die sich im "Normalfall" ergibt. Wird jedoch ein Nulldurchgang des Laststroms $i_x$ im Sperrintervall der Leistungsschalter erkannt, erfolgt eine Berechnung der Kompensationsgröße $u_{comp}$, so dass die resultierende und korrigierte Größe, mit der das Lastmodell 7 beaufschlagt wird, sich berechnet aus der Summe aus der Strangspannung $u_x$ und der Kompensationsgröße $u_{comp,x}$. Es gilt also bei einem Nulldurchgang des Stromes

$$u_x^* = u_x + u_{comp,x}$$

wohingegen bei keinem Nulldurchgang des Stromes - kein Lückbetrieb - weiterhin gilt:

$$u_x^* = u_x$$

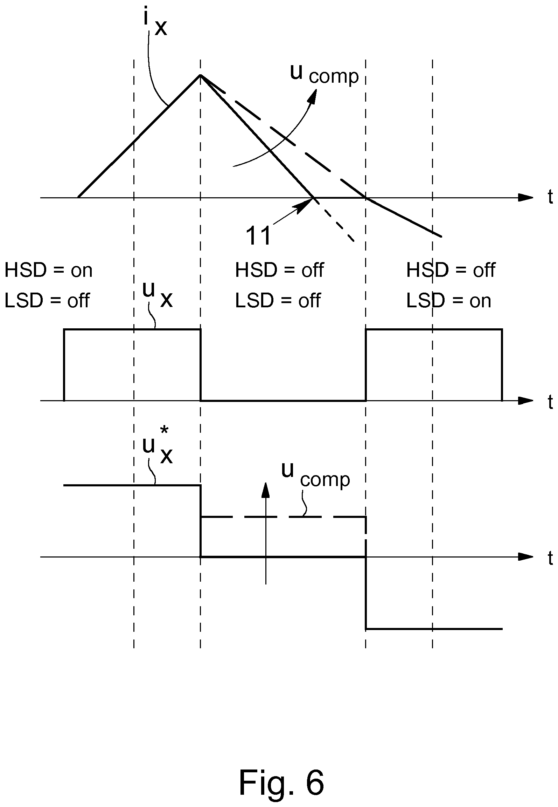

Fig. 6 verdeutlicht anhand einer Skizze der Verläufe der Stromrichtersteuerdaten in Form von PWM-Signalen 6, des Laststroms $i_x$ und der Kompensationsgröße in Form der Kompensationsspannung $u_{comp}$ das Wirkprinzip des Beobachters 9. Wenn der Laststrom $i_x$ nur mit dem einfachen Lastmodell 7 berechnet wird, wird ein Nulldurchgang des Stromes $i_x$ und damit die Stromlücke 11 nicht erkannt. Das Lastmodell 7 rechnet quasi ungeachtet des erzwungenen Verharrens des Laststromes $i_x$ auf dem Wert Null mit den zuvor geltenden gleichungsmäßigen Beschreibungen weiter, was zu dem falschen Stromverlauf $i_x$ führt, der punktiert dargestellt ist. Die Idee besteht darin, eine Kompensationsspannung $u_{comp}$ zu bestimmen, dass diese in Zusammenhang mit der Stromrichterspannung $u_x$ so auf die Berechnung des Laststromes $i_x$ durch das einfache Lastmodell 7 einwirkt, dass das gleiche Ergebnis für den Laststrom $i_x$ resultiert, als wenn der Lückbetrieb schon im Lastmodell 7 berücksichtigt worden wäre. In Fig. 6 ist zu erkennen, dass durch die zusätzliche Wirkung der Kompensationsspannung der Verlauf des Laststromes $i_x$ angehoben wird - gestrichelter Verlauf von $i_x$ - so dass der Strom am Ende des Lückintervalls tatsächlich auf Null abgesunken und nicht fehlerhaft negativ berechnet worden ist.

Die Größe der erforderlichen Kompensationsspannung $u_{comp}$ lässt sich recht einfach berechnen, da ein fehlerhaft berechneter Strom durch eine Spule, in Fig. 6 der punktierte Verlauf des Laststromes $i_x$, einer Spannungszeitfläche entspricht, also einer Spannung, die eine gewisse Zeit auf die Spule eingewirkt hat, um die (fehlerhafte) Stromänderung zu bewirken. Mit dem Wissen, dass im Falle der in Fig. 2 dargestellten dreiphasigen Last während des Lückbetriebes ($i_x = 0$) die stromrichterseitige Spannung an der Last gleich der gemeinsamen Sternspannung uo der drei Stränge ist und sich die Sternspannung einfach berechnen lässt durch

$$u_0 = \frac{u_a + u_b + u_c}{3}$$

stellt sich nur noch die Frage nach der Dauer des Lückbetriebes, also nach der Summe der Stromlückzeitintervalle $t_{zero}$.

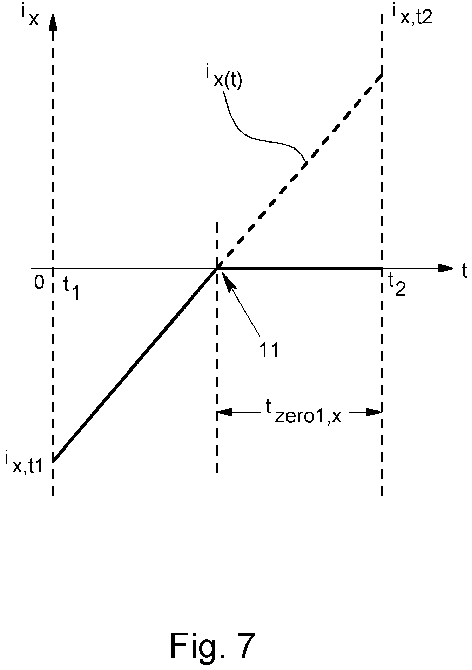

In Fig. 7 ist ein mit dem Beobachter-Lastmodell 10 berechneter Verlauf für den Laststrom $i_x$ dargestellt, wobei aufgrund der Berechnung die Werte $i_{x,t1}$, $i_{x,t2}$ für den Laststrom $i_x$ zu den Zeitpunkten $t_1$, $t_2$ am Anfang und am Ende des Beobachterzeitintervalls bekannt sind. Durch den Vorzeichenwechsel des berechneten Laststroms $i_x$ kann auf einen Nulldurchgang des Laststroms

$i_x$ geschlussfolgert werden, der dann mit einer Stromlücke 11 verknüpft ist, wenn in dem betrachteten Beobachterzeitintervall alle die Last speisenden Leistungsschalter gesperrt sind, wovon hier ausgegangen wird. Damit zur Bestimmung des Nullpunktes nicht ein aufwendiges iteratives Verfahren verwendet werden muss, wird der Stromverlauf $i_x$ durch die Last in Beobachterzeitintervallen mit einem Nulldurchgang des Laststromes $i_x$ linear approximiert, wie in Fig. 7 dargestellt. In diesem Fall lässt sich das Stromlückzeitintervall $t_{zero1,x}$ einfach durch den Beobachter 9 berechnen, da lediglich der Nullpunkt einer Geraden zu ermitteln ist. Für die in Fig. 7 dargestellte Situation ergibt sich für das Stromlückzeitintervall $t_{zero1}$:

$$t_{zero1,x} = \frac{abs(i_{x,t2})}{abs(i_{x,t1}) + abs(i_{x,t2})}(t_2 - t_1)$$

Falls es zu einer weiteren Stromlücke in einem Stromlückzeitintervall $t_{zero2}$ mit den Intervallgrenzen t3 und t4 käme, dann würde entsprechend gelten:

$$t_{zero2,x} = \frac{abs(i_{x,t4})}{abs(i_{x,t3}) + abs(i_{x,t4})}(t_4 - t_3)$$

Damit wäre dann im Rahmen eines Mittelwertmodells als Lastmodell 7, das nur eine Berechnung innerhalb einer PWM-Periodendauer vollzieht, die Kompensationsspannung zu berechnen durch

$$u_{comp,x} = \frac{t_{zero1,x} + t_{zero2,x}}{T_{PWM}} u_0$$

Anhand der Gleichungen ist gut zu erkennen, dass wenn als Kompensationsgröße eine Kompensationsspannung $u_{comp}$ berechnet wird, die Kompensationsspannung $u_{comp}$ insbesondere abhängt von dem Verhältnis des Stromlückzeitintervalls $t_{zero}$ (bzw. zur Summe der Stromzeitintervalle innerhalb des Berechnungsintervalls) zur Schaltperiodendauer $T_{PWM}$ des Stromrichters. Bei mehrphasigen Systemen wird die aufgezeigte Berechnung für jeden Strang durchgeführt, wobei jeder Strang einen eigenen Beobachter aufweist. Das Lastmodell 7 wird mit einer Spannung beaufschlagt, bei der die durch den Beobachter 9 berechnete Kompensationsspannung $u_{comp,x}$ zu der durch den Stromrichter geschalteten Lastspannung $u_x$ addiert wird, so dass die Berechnung des Laststroms $i_x$ mit dem Lastmodell 7 auf Grundlage der Summenspannung an der Last erfolgt.

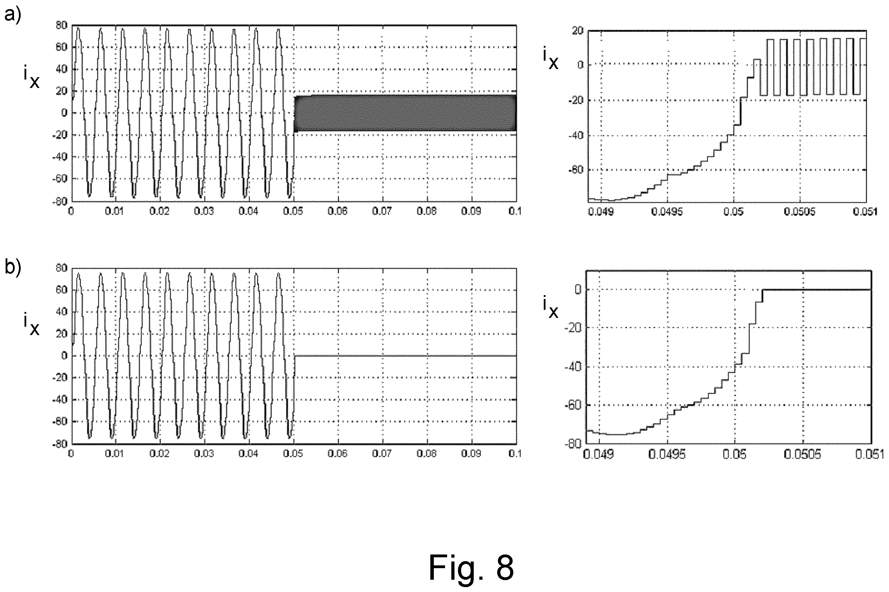

Fig. 8 zeigt die Berechnung des Laststrom $i_x$ auf konventionelle Weise, also auf Basis eines Lastmodells 7, das Stromlücken nicht berücksichtigt (Fig. 8a) und auf Basis des gleichen Lastmodells 7, das allerdings mit der durch den beschriebenen Beobachter 9 berechneten Kompensationsspannung $u_{comp,x}$ zusätzlich beaufschlagt wird (Fig. 8b). Bei beiden Berechnungen sperren alle Leistungsschalter ab dem Zeitpunkt 50 ms. Die unkorrigierte Rechnung in Fig. 8a endet in einer fehlerhaften Dauerschwingung des Laststromes $i_x$, wohingegen die durch den Beobachter 9 korrigierte Berechnung zu einem richtigen stationären Null-Laststrom $i_x$ führt.

**Patentansprüche**

1. Computerimplementiertes Verfahren zum Echtzeittest eines Steuergeräts (1) mit einem Simulator (2), wobei der Simulator (2) eine Simulator-I/O-Schnittstelle (3) umfasst, wobei das Steuergerät (1) eine Steuergerät-I/O-Schnittstelle (4) umfasst und wobei das Steuergerät (1) und der Simulator (2) über ihre I/O-Schnittstellen (3, 4) mittels wenigstens eines Datenkanals (5) miteinander verbunden sind und das Steuergerät (1) dem Simulator (2) über den Datenkanal (5) Stromrichtersteuerdaten (6) übermittelt, der Simulator (2) mittels der Stromrichtersteuerdaten (6) und mittels eines elektrischen Lastmodells (7) ohne Berücksichtigung von durch den Stromrichter (8) verursachten Stromlücken (11) als elektrische Lastzustandsgrößen einen Laststrom ($i_x$) und eine Lastspannung ($u_x$) berechnet und zumindest einen Teil der Lastzustandsgrößen an das Steuergerät (1) übermittelt,
**dadurch gekennzeichnet,**

- **dass** auf dem Simulator (2) zusätzlich ein regelungstechnischer Beobachter (9) ausgeführt wird,
- der Beobachter (9) unter Berücksichtigung der Stromrichtersteuerdaten (6) und mit einem Beobachter-Lastmodell (10) wenigstens den Laststrom ($i_x$) als Lastzustandsgröße berechnet,
- der Beobachter (9) aus dem berechneten Laststrom ($i_x$) einen Nulldurchgang des Laststroms ($i_x$) und eine dadurch verursachte Stromlücke (11) detektiert,
- der Beobachter (9) bei Detektion einer Stromlücke (11) eine elektrische Kompensationsgröße ($u_{comp}$) so berechnet, dass bei zusätzlicher Beaufschlagung der elektrischen Last im Lastmodell (7) mit der Kompensationsgröße ($u_{comp}$) die Berechnung des Laststroms ($i_x$) mit dem Lastmodell (7) mit reduziertem Fehler bei existierenden Stromlücken (11) erfolgt.

2. Computerimplementiertes Verfahren nach Anspruch 1, **dadurch gekennzeichnet, dass** es sich bei der durch das Lastmodell (7) modellierten Last um eine elektrische Maschine, insbesondere um eine Kommutatormaschine, eine Asynchronmaschine oder eine Synchronmaschine handelt, wobei der Strang bzw. die Stränge der Maschinen durch wenigstens ein RLC-Netzwerk, insbesondere durch wenigstens ein RL-Netzwerk mathematisch nachgebildet werden.

3. Computerimplementiertes Verfahren nach Anspruch 1 oder 2, **dadurch gekennzeichnet, dass** die Berechnung des Beobachter-Lastmodells (10) in Beobachterzeitintervallen erfolgt, die durch externe Schaltereignisse des Stromrichters synchronisiert sind, die insbesondere durch Auswertung der Stromrichtersteuerdaten (6) ermittelt werden.

4. Computerimplementiertes Verfahren nach einem der Ansprüche 1 bis 3, **dadurch gekennzeichnet, dass** das Beobachter-Lastmodell (10) wenigstens eine explizite Funktion für die zu berechnende Lastzustandsgröße ($i_x$, $u_x$) aufweist.

5. Computerimplementiertes Verfahren nach Anspruch 4, **dadurch gekennzeichnet, dass** die expliziten Funktionen Lösungsfunktionen für lineare Differentialgleichungen sind, die das Beobachter-Lastmodell (10) bilden.

6. Computerimplementiertes Verfahren nach einem der Ansprüche 1 bis 3, **dadurch gekennzeichnet, dass** das Beobachter-Lastmodell (10) ein Mittelwertmodell ist, insbesondere wobei das Beobachter-Lastmodell (10) numerisch berechnet wird.

7. Computerimplementiertes Verfahren nach Anspruch 6, **dadurch gekennzeichnet, dass** die Berechnung des Beobachter-Lastmodells (10) durch mit dem Lastmodell (7) berechnete Lastzustandsgrößen ($u_x$, $i_x$) getrieben wird.

8. Computerimplementiertes Verfahren nach einem der Ansprüche 1 bis 7, **dadurch gekennzeichnet, dass** der Beobachter (9) durch einen Vorzeichenwechsel des berechneten Laststroms ($i_x$) einen Nulldurchgang des Laststroms ($i_x$) und eine dadurch verursachte Stromlücke (11) detektiert, insbesondere durch Auswertung der Werte des Laststroms ($i_x$) am Anfang und am Ende von Beobachterzeitintervallen, insbesondere von Beobachterzeitintervallen, in denen kein Element des Stromrichters durch entsprechende Stromrichtersteuerdaten (6) durchgeschaltet ist.

9. Computerimplementiertes Verfahren nach Anspruch 8, **dadurch gekennzeichnet, dass** der Stromverlauf in Beobachterzeitintervallen mit einem Nulldurchgang des Laststroms ($i_x$) linear approximiert wird.

10. Computerimplementiertes Verfahren nach einem der Patentansprüche 1 bis 9, **dadurch gekennzeichnet, dass** der Beobachter (9) bei Detektion eines Nulldurchgangs des Laststroms ($i_x$) und einer dadurch verursachten Stromlücke (11) das Stromlückzeitintervall ($t_{zero}$) berechnet.

**11.** Computerimplementiertes Verfahren nach Anspruch 10, **dadurch gekennzeichnet, dass** der Beobachter (9) als Kompensationsgröße eine Kompensationsspannung ($u_{comp}$) berechnet, wobei die Kompensationsspannung ($u_{comp}$) insbesondere abhängt von dem Verhältnis des Stromlückzeitintervalls ($t_{zero}$) zur Schaltperiodendauer ($T_{PWM}$) des Stromrichters.

**12.** Computerimplementiertes Verfahren nach Anspruch 11, **dadurch gekennzeichnet, dass** im Lastmodell (7) die durch den Beobachter (9) berechnete Kompensationsspannung ($u_{comp}$) zu der durch den Stromrichter geschalteten Lastspannung ($u_x$) addiert wird, so dass die Berechnung des Laststroms ($i_x$) mit dem Lastmodell (7) auf Grundlage der Summenspannung ($u_x^*$) an der Last erfolgt.

**13.** Computerimplementiertes Verfahren nach einem der Ansprüche 1 bis 12, **dadurch gekennzeichnet, dass** das elektrische Lastmodell (7) mit einem Prozessor des Simulators (2) berechnet wird und dass der Beobachter (9) mit einem anderen Prozessor des Simulators (2) berechnet wird oder der Beobachter (9) mit einem FPGA des Simulators (2) berechnet wird.

**14.** Computerprogrammprodukt mit einem Computerprogramm, das Softwaremittel zur Durchführung des Verfahrens nach einem der Ansprüche 1 bis 13 aufweist, wenn das Computerprogramm mit einem Simulator ausgeführt wird.

**Claims**

**1.** Computer-implemented method for real-time testing of a control unit (1) with a simulator (2), wherein the simulator (2) includes a simulator I/O interface (3), wherein the control unit (1) includes a control unit I/O interface (4), and wherein the control unit (1) and the simulator (2) are connected to one another through their I/O interfaces (3, 4) by means of at least one data channel (5), and the control unit (1) transmits converter control data (6) to the simulator (2) through the data channel (5), the simulator (2) calculates a load current ($i_x$) and a load voltage ($u_x$) as electrical load state variables by means of the converter control data (6) and by means of an electrical load model (7) that does not take into account current discontinuities (11) caused by the converter (8) and transmits at least a portion of the load state variables to the control unit (1),
**characterized in that**

- a control observer (9) is additionally implemented on the simulator (2),
- the observer (9) calculates at least the load current ($i_x$) as a load state variable, taking into account the converter control data (6) and with an observer load model (10),
- the observer (9) detects a zero-crossing of the load current ($i_x$) and a current discontinuity caused thereby (11) from the calculated load current ($i_x$),
- upon detection of a current discontinuity (11), the observer (9) calculates an electrical compensating quantity ($u_{comp}$) such that when the compensating quantity ($u_{comp}$) is additionally applied to the electrical load in the load model (7), the calculation of the load current ($i_x$) using the load model (7) takes place with reduced error in the presence of current discontinuities (11).

**2.** Computer-implemented method according to claim 1, **characterized in that** the load modeled by the load model (7) is an electric machine, in particular a commutated machine, an asynchronous machine, or a synchronous machine, wherein the phase or phases of the machine are mathematically reproduced by at least one RLC network, in particular by at least one RL network.

**3.** Computer-implemented method according to claim 1 or 2, **characterized in that** the calculation of the observer load model (10) takes place in observer time intervals that are synchronized by external switching events of the converter, that in particular are determined by analysis of the converter control data (6).

**4.** Computer-implemented method according to one of claims 1 to 3, **characterized in that** the observer load model (10) contains at least one explicit function for the load state variable ($i_x$, $u_x$) to be calculated.

**5.** Computer-implemented method according to claim 4, **characterized in that** the explicit functions are solution functions for linear differential equations that constitute the observer load model (10).

**6.** Computer-implemented method according to one of claims 1 to 3, **characterized in that** the observer load model (10) is an average-value model, in particular wherein the observer load model (10) is calculated numerically.

**7.** Computer-implemented method according to claim 6, **characterized in that** the calculation of the observer load model (10) is driven by load state variables ($u_x$, $i_x$) calculated with the load model (7).

**8.** Computer-implemented method according to one of claims 1 to 7, **characterized in that** the observer (9) detects a zero-crossing of the load current ($i_x$) and a current discontinuity (11) caused thereby by a change in sign of the calculated load current ($i_x$), in particular by analyzing the values of the load current ($i_x$) at the beginning and at the end of observer time intervals, in particular of observer time intervals during which no element of the converter is switched on by corresponding converter control data (6).

9. Computer-implemented method according to claim 8, **characterized in that** the behavior of the current in observer time intervals with a zero-crossing of the load current ($i_x$) is approximated linearly.

10. Computer-implemented method according to one of claims 1 to 9, **characterized in that** the observer (9) calculates the current discontinuity time interval ($t_{zero}$) upon detection of a zero-crossing of the load current ($i_x$) and of a current discontinuity (11) caused thereby.

11. Computer-implemented method according to claim 10, **characterized in that** the observer (9) calculates a compensating voltage ($u_{comp}$) as the compensating quantity, wherein the compensating voltage ($u_{comp}$) depends in particular on the ratio of the current discontinuity time interval ($t_{zero}$) to the switching period duration ($T_{PWM}$) of the converter.

12. Computer-implemented method according to claim 11, **characterized in that** the compensating voltage ($u_{comp}$) calculated by the observer (9) is added in the load model (7) to the load voltage ($u_x$) switched by the converter, so that the calculation of the load current ($i_x$) with the load model (7) takes place on the basis of the summed voltage ($u_x^*$) at the load.

13. Computer-implemented method according to one of claims 1 to 12, **characterized in that** the electrical load model (7) is calculated with a processor of the simulator (2), and **in that** the observer (9) is calculated with a different processor of the simulator (2), or the observer (9) is calculated with an FPGA of the simulator (2).

14. Computer program product with a computer program that has software means for carrying out the method according to one of claims 1 to 13 when the computer program is executed with a simulator.

**Revendications**

1. Procédé mis en oeuvre sur ordinateur pour tester en temps réel un appareil de commande (1) avec un simulateur (2), dans lequel le simulateur (2) comporte une interface E/S (3) de simulateur, dans lequel l'appareil de commande (1) comporte une interface E/S (4) d'appareil de commande et dans lequel l'appareil de commande (1) et le simulateur (2) sont reliés l'un à l'autre via leurs interfaces E/S (3, 4) au moyen d'au moins une voie de données (5) et l'appareil de commande (1) transmet au simulateur (2) des données de commande (6) de convertisseur via la voie de données (5), le simulateur (2), à l'aide des données de commande (6) de convertisseur et à l'aide d'un modèle de charge (7) électrique, calcule en tant que grandeurs d'état de charge électrique un courant de charge ($i_x$) et une tension de charge ($u_x$) sans tenir compte des interruptions de courant (11) provoquées par le convertisseur (8), et transmet au moins partie des grandeurs d'état de charge à l'appareil de commande (1),
**caractérisé en ce que**

- un observateur de régulation (9) est de plus exécuté sur le simulateur (2),
- l'observateur (9) calcule au moins le courant de charge ($i_x$) en tant que grandeur d'état de charge compte tenu des données de commande (6) de convertisseur et avec un modèle de charge (10) de l'observateur,
- l'observateur (9) détecte sur la base du courant de charge ($i_x$) calculé un passage par zéro du courant de charge ($i_x$) et une interruption de courant (11) provoquée de ce fait,
- l'observateur (9), en cas de détection d'une interruption de courant (11), calcule une grandeur de compensation ($u_{comp}$) électrique de sorte que, en cas d'application supplémentaire de la grandeur de compensation ($u_{comp}$) sur la charge électrique dans le modèle de charge (7), le calcul du courant de charge ($i_x$) avec le modèle de charge (7) est effectué avec une erreur réduite en cas d'existence d'interruptions de courant (11).

2. Procédé mis en oeuvre sur ordinateur selon la revendication 1, **caractérisé en ce que** la charge modelée par le modèle de charge (7) est une machine électrique, une machine à collecteur, une machine asynchrone ou une machine synchrone, sachant que l'écheveau ou les écheveaux des machines sont représentés mathématiquement par au moins un réseau RLC, en particulier par au moins un réseau RL.

3. Procédé mis en oeuvre sur ordinateur selon la revendication 1 ou 2, **caractérisé en ce que** le calcul du modèle de charge (10) d'observateur s'effectue en intervalles de temps d'observateur, qui sont synchronisés par des évènements de commutation externes du convertisseur, qui sont déterminés en particulier par analyse des données de commande (6) de convertisseur.

**4.** Procédé mis en oeuvre sur ordinateur selon l'une des revendications 1 à 3, **caractérisé en ce que** le modèle de charge (10) d'observateur comporte au moins une fonction explicite pour la grandeur d'état de charge ($i_x$, $u_x$) devant être calculée.

**5.** Procédé mis en oeuvre sur ordinateur selon la revendication 4, **caractérisé en ce que** les fonctions explicites sont des fonctions de résolution pour des équations différentielles linéaires, qui constituent le modèle de charge (10) d'observateur.

**6.** Procédé mis en oeuvre sur ordinateur selon l'une des revendications 1 à 3, **caractérisé en ce que** le modèle de charge (10) d'observateur est un modèle à valeur moyenne, dans lequel, en particulier, le modèle de charge (10) d'observateur est calculé numériquement.

**7.** Procédé mis en oeuvre sur ordinateur selon la revendication 6, **caractérisé en ce que** le calcul du modèle de charge (10) d'observateur s'effectue sur la base de grandeurs d'état de charge ($u_x$, $i_x$) calculés par le modèle de charge (7).

**8.** Procédé mis en oeuvre sur ordinateur selon l'une des revendications 1 à 7, **caractérisé en ce que** l'observateur (9), par un changement de signe du courant de charge ($i_x$) calculé, détecte un passage par zéro du courant de charge ($i_x$) et une interruption de courant (11) provoqué de ce fait, en particulier par analyse des valeurs du courant de charge ($i_x$) au début et à la fin d'intervalles de temps de l'observateur, en particulier d'intervalles de l'observateur dans lesquels aucun élément du convertisseur n'est connecté en transfert par des données de commande (6) de convertisseur afférentes.

**9.** Procédé mis en oeuvre sur ordinateur selon la revendication 8, **caractérisé en ce que** l'allure du courant dans les intervalles de temps de l'observateur est approximée linéairement par un passage par zéro du courant de charge ($i_x$).

**10.** Procédé mis en oeuvre sur ordinateur selon l'une des revendications 1 à 9, **caractérisé en ce que** l'observateur (9) calcule l'intervalle de temps ($t_{zero}$) de l'interruption de courant à la détection d'un passage à zéro du courant de charge ($i_x$) et d'une interruption de courant (11) provoquée de ce fait.

**11.** Procédé mis en oeuvre sur ordinateur selon la revendication 10, **caractérisé en ce que** l'observateur (9) calcule en tant que grandeur de compensation une tension de compensation ($u_{comp}$), sachant que la tension de compensation ($u_{comp}$) dépend en particulier du rapport de l'intervalle de temps ($t_{zero}$) de l'interruption de courant à la durée de cycle de commutation ($T_{PWM}$) du convertisseur.

**12.** Procédé mis en oeuvre sur ordinateur selon la revendication 11, **caractérisé en ce que** dans le modèle de charge (7), la tension de compensation ($u_{comp}$) calculée par l'observateur (9) est additionnée à la tension de charge ($u_x$) connectée par le convertisseur, de sorte que le calcul du courant de charge ($i_x$) s'effectue avec le modèle de charge (7) sur la base de la tension de somme ($u_x^*$) à la charge.

**13.** Procédé mis en oeuvre sur ordinateur selon l'une des revendications 1 à 12, **caractérisé en ce que** le modèle de charge (7) électrique est calculé à l'aide d'un processeur du simulateur (2) et que l'observateur (9) est calculé avec un processeur différent du simulateur (2) ou l'observateur (9) est calculé avec un réseau de portes programmables (FPGA) du simulateur (2).

**14.** Produit de programme informatique avec un programme informatique, qui comporte des moyens pour la réalisation du procédé selon l'une des revendications 1 à 13 lorsque le programme informatique est exécuté à l'aide d'un simulateur.

## Fig. 1

(Stand der Technik)

Fig. 2

Fig. 3

Fig. 4

Fig. 5

HSD = on
LSD = off

HSD = off
LSD = off

HSD = off
LSD = on

Fig. 6

Fig. 7

Fig. 8

EP 2 933 695 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Real-time simulation of power electronic circuits based on discrete averaging method. **AXEL KIFFE et al.** IECON 2011 - 37TH ANNUAL CONFERENCE ON IEEE INDUSTRIAL ELECTRONICS SOCIETY. IEEE, 07. November 2011, 1542-1547